# EUROPÄISCHE PATENTSCHRIFT

(11) **EP 0 312 845 B1**
(45) Veröffentlichungstag und Bekanntmachung des Hinweises auf die Patenterteilung: **26.05.1993**
(21) Anmeldenummer: 88116586.4
(22) Anmeldetag: 06.10.1988
(51) Int. Cl.: G01S 15/93, G01S 15/87, G01S 7/52, H03K 17/95, G01H 3/00

(54) **Überwachungseinrichtung für Rückwärtsfahrtsicherungen bei Fahrzeugen**
Monitoring device for reversing vehicles
Dispositif de surveillance pour véhicules en marche arrière

(30) Priorität: 19.10.1987 DE 3735344
(43) Veröffentlichungstag der Anmeldung: 26.04.1989
(73) Patentinhaber: SIEMENS AKTIENGESELLSCHAFT, 80333 München (DE)
(72) Erfinder: Riedel, Hans-Dieter, D-8520 Erlangen (DE)

(56) Entgegenhaltungen:
- DE-A- 1 805 834
- DE-A- 3 207 950
- DE-A- 3 420 004
- US-A- 3 881 805
- US-A- 3 975 698
- US-A- 4 542 489
- US-A- 4 625 829
- US-A- 4 636 997
- PATENT ABSTRACTS OF JAPAN, Band 7, Nr. 176 (P-214)[1321], 4. August 1983;& JP-A-58 80 574
- ELEKTRONIK, Band 35, Nr. 22, Oktober 1986, Seiten 48-50, München, DE; E.K. ASCHMONEIT: "Fahrzeugtechnik: Ultraschall-Warner für Rückwärtsfahrt im Auto"
- PATENT ABSTRACTS OF JAPAN, Band 10, Nr. 195 (P-475)[2251], 9. Juli 1986;& JP-A-61 38 479

## Beschreibung

Die vorliegende Erfindung betrifft eine Überwachungseinrichtung für Rückwärtsfahrtsicherungen bei Fahrzeugen mit mindestens zwei am Fahrzeugheck angeordneten, im Schallreflexionsverfahren (Echolot) betriebenen Sender-/Empfängerpaaren, denen jeweils ein elektroakustischer Wandler zugeordnet ist.

Rückwärtsfahrsicherungen der vorgenannten Art sind nach der Zeitschrift "Elektronik", 22/31.10.1986, Seiten 48, 50 bekannt und es sind bei diesen Ultraschall-Warnern auch selbsttätige Prüfläufe vorgesehen, um eine Fehlfunktion der elektronischen Auswerteschaltung anzuzeigen. Fehlerhaftes Arbeiten der Rückwärtsfahrtsicherung infolge von Umwelteinflüssen auf die Sensoren, d.h. die elektroakustischen Wandler, lassen sich mit derartigen Prüfläufen nicht erkennen. Aufgabe der Erfindung ist es, eine einfache Überwachungseinrichtung für Rückwärtsfahrtsicherungen der eingangs genannten Art anzugeben, welche während des Betriebs zuverlässig nicht nur bei Bauelementeausfall sondern auch bei Verschmutzung, Befeuchtung, Vereisung o.dgl. der Wandler ein Fehlverhalten meldet.

Die Lösung dieser Aufgabe gelingt erfindungsgemäß mit den im kennzeichnenden Teil des Anspruchs 1 angegebenen Merkmalen. Grundgedanke der Erfindung ist es also, jeweils mit einem Teil der ausgestrahlten Nutzschalleistung den Empfänger eines anderen, nicht zur Objektmessung verwendeten Empfängers zu einem Funktionskontrollsignal zu veranlassen und dieses dann auszuwerten. Damit wird eine vollständige Funktionskontrolle solcher Warngeräte erreicht.

Die Erfindung samt deren weiteren Ausgestaltungen, welche in Unteransprüchen gekennzeichnet sind, soll nachstehend anhand der Figuren näher erläutert werden. Darin zeigen:
- FIG 1: die Anordnung der elektroakustischen Wandler am Fahrzeugheck,
- FIG 2 - 4: drei Varianten zur konstruktiven Realisation des akustischen Nebenschlusses,
- FIG 5: ein Blockschaltbild für eine Rückwärtsfahrtsicherung mit einer Überwachungseinrichtung, und
- FIG 6: hierzu gehörige Impulsdiagramme.

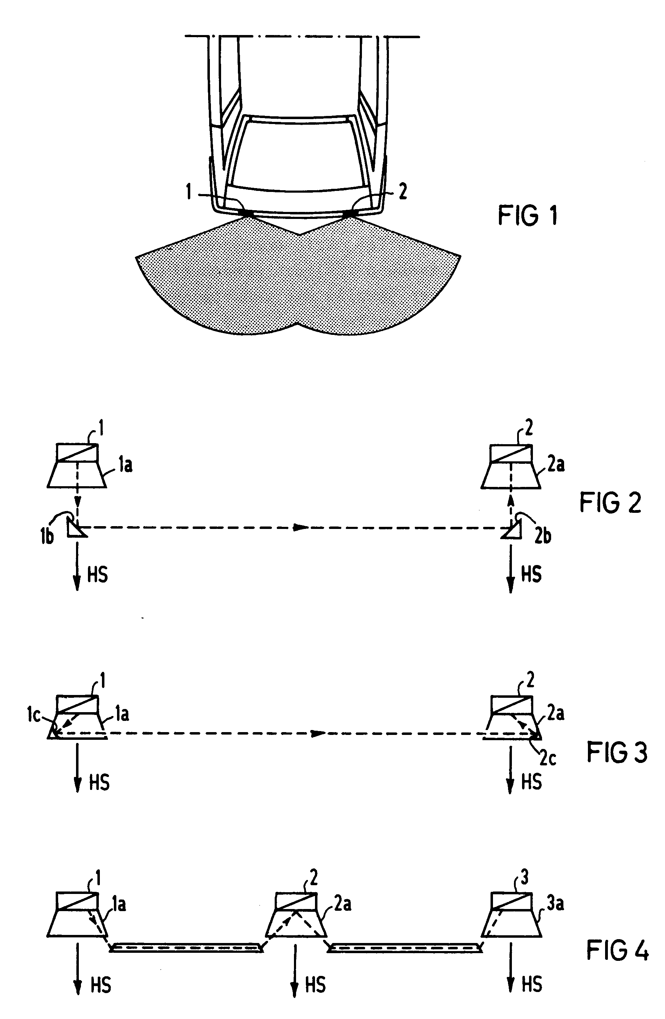

FIG 1 zeigt die bekannte Anordnung zweier elektroakustischer Wandler 1 und 2 an der Heckstoßstange eines teilweise dargestellten Kraftfahrzeuges. In dem gerasterten Erfassungsbereich befindliche Objekte reflektieren einen Teil des von den elektroakustischen Wandlern ausgestrahlten Schalls zu den Wandlern zurück und werden dadurch als Hindernisse erkannt. Aus dem Zeitverzug zwischen der Ausstrahlung des Schalles und dem Eintreffen des Echos kann auf den Abstand zwischen dem Objekt und dem Fahrzeugheck geschlossen werden.

FIG 2 zeigt schematisch eine Möglichkeit zur Realisierung des akustischen Nebenschlusses zwischen zwei Wandlern, d.h. zur Umlenkung eines Teiles des von einem Sender ausgestrahlten Schalles zum Empfänger des Nachbarwandlers. Mit 1 und 2 sind die elektroakustischen Wandler bezeichnet, welche mit Schalltrichtern 1a und 2a zur Ausrichtung der Schallabstrahlung verbunden sind. In der Mittenachse der Hauptstrahlrichtung, welche jeweils mit einem mit HS bezeichneten Pfeil angedeutet ist, sind jeweils unter 45° zu dieser geneigte Schallreflexionsflächen 2a bzw. 2b angeordnet, welche beispielsweise von prismatischen Körpern gebildet werden können. Wenn der dem akustischen Wandler 1 zugeordnete Sender aktiviert ist, kann von dem durch ihn ausgestrahlten Schall infolge der Schallreflexionsfläche 1b ein Teil abgezweigt werden, welcher nach Umlenkung durch die dem elektroakustischen Wandler 2 zugeordnete Schallreflexionsfläche 2b zu dem diesem Wandler zugeordneten Empfänger gelangen kann. Da die den Wandlern 1 und 1 zugeordneten Sender nie gleichzeitig arbeiten, sondern zyklisch abwechselnd betrieben werden, kann in der Zeit, in welcher der dem Wandler 1 zugeordnete Sender zur Objektmessung verwendet wird, gleichzeitig die Funktionsfähigkeit des dem Wandler 2 zugeordneten Empfängers überprüft werden und umgekehrt, in der Zeit, in welcher der dem Wandler 2 zugeordnete Sender aktiv ist, kann die Funktionsfähigkeit des dem Wandler 1 zugeordneten Empfängers festgestellt werden. Auf diese Weise findet eine wechselseitige Überprüfung von Sender-/Empfängerfunktionen zwischen benachbarten Wandlern statt.

FIG 3 zeigt eine Variante der Erfindung, bei der die Umlenkung, d.h. die Realisierung des akustischen Nebenschlusses mittels konkav gewölbter Reflexionsflächen 1c und 2c erfolgt, welche an der Innenwandung der Schalltrichter 1a bzw. 2a befestigt sind. Gegenüber den Reflexionsflächen 1c und 2c weisen die Schalltrichter 1a und 2a Schallöffnungen auf. Wiederum wird der Schall senkrecht zur Hauptrichtung HS des Schalles umgelenkt.

Soll in unmittelbarer Nähe der Heckstoßstange ein Erfassungsbereich über die gesamte Länge derselben realisiert werden, so läßt sich dies mit drei oder mehr elektroakustischen Wandlern erreichen, welche in regelmäßigem Abstand an der Stoßstange angebracht werden. FIG 4 zeigt hierzu eine Variante, bei welcher die Realisierung des Nebenschlusses durch jeweils zwischen zwei benachbarten Wandlern angeordneten Rohren bewirkt ist. Um eine gute Schalleitung zu erreichen, sollten die Rohre innen glattwandig und aus hartem Material, beispielsweise Metall oder Kunststoff bestehen. Um möglichst viel von dem durch den jeweiligen Sender ausgesandten Schall aufzufangen, ist es zweckmäßig, die Rohrenden, wie dargestellt, abzuschrägen oder trichterförmig auszubilden.

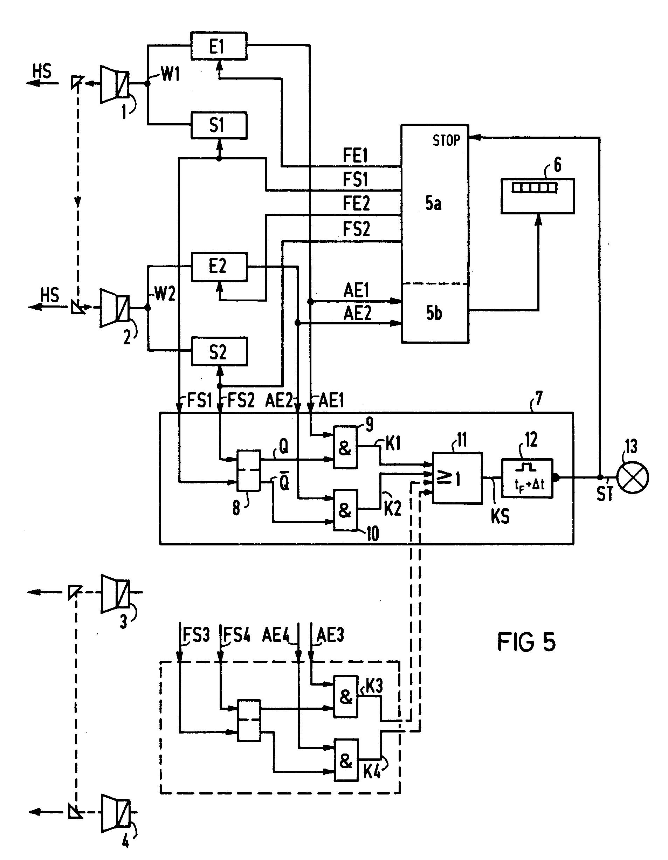

FIG 5 zeigt ein Beispiel zur Auswertung von mittels des erfindungsgemäß eingereichten akustischen Nebenschlusses erzeugten Kontrollsignalen. Der obere Teil der FIG 5 enthält den üblichen Aufbau einer Rückwärtsfahrtsicherung von Fahrzeugen mit zwei elektroakustischen Wandlern 1 und 2. Diesen ist jeweils ein Sender-/Empfängerpaar, bestehend aus den Empfängern E1, E2 und den Sendern S1, S2, zugeordnet. Die Sender S1 bzw. S2 enthalten hochfrequent schwingende Oszillatoren, deren Ausgangsspannung kurzzeitig mit Freigabesignalen FS1 bzw. FS2 einer Ablaufsteuerung 5a zu den elektroakustischen Wandlern 1 bzw. 2 durchgeschaltet werden. Die Ablaufsteuerung 5 stellt weiterhin Freigabesignale FE1 bzs. FE2 bereit, mit welchen die Ausgangssignale AE1 bzw. AE2 der Empfänger E1 bzw. E2 einer Meßsignalauswertung 5b, zugeführt werden. Die Freigabe der Ausgangssignale AE1 bzw. AE2 kann so erfolgen, daß durch ein Freigabesignal FE1 bzw. FE2 ein Kurzschluß im Eingang des betreffenden Empfängers aufgehoben wird. Zur Vermeidung von Rückkopplungen und insbesondere von Überlastungen der Empfänger wird von der Ablaufsteuerung 5a dafür gesorgt, daß zu den Zeiten, in welchen die Sender die Wandler beaufschlagen, die Empfänger nicht durch die Freigabesignale FE1 und FE2 freigegeben, d.h. ihre Eingänge kurzgeschlossen sind. In den Empfängern E1 und E2 erfolgt eine Aufbereitung des empfangenen hochfrequenten Signals zu einem digital verarbeitbarem Impuls. Die Steuerung der Sender-/Empfängerpaare erfolgt zur Objektmessung zyklisch abwechselnd in der Weise, daß nach kurzzeitiger Freigabe des Senders S1 der Empfänger E1 freigegeben wird, und nach einer bestimmten Zeit t_{F} der Sender S2 kurzzeitig freigegeben wird und daran anschließend die Freigabe des Empfängers E2 erfolgt. Nachdem eine Zeit von t_{F} seit Freigabe des Senders S2 verstrichen ist, beginnt ein neuer Meßzyklus mit der Freigabe des Senders S1. Die Auswerteschaltung 5b ermittelt aus dem Zeitverzug zwischen der Schallausssendung und dem Empfang des vom Objekt reflektierten Schalls seinen Abstand vom Fahrzeugheck und macht diesen mittels einer Anzeigevorrichtung 6 sichtbar.

Die Überwachungseinrichtung 7 für zwei gemäß FIG 2 mit einem akustischen Nebenschluß versehenen Wandler 1 bzw. 2 enthält eine bistabile Kippstufe 8, welche eingangsseitig von den Senderfreigabesignalen FS1 bzw. FS2 beaufschlagt sind. Die Ausgangssignale Q und Q̅ der bistabilen Kippstufe 8 sind zwei UND-Gattern 9 und 10 zugeführt, an deren anderen Eingängen die Ausgangssignale AE1 und AE2 der Empfänger E1 und E2 angeschlossen sind. Diese UND-Gatter stellen elektronische Torschaltungen dar, welche immer dann durchlässig für ein vom Nachbarsender empfangenes Signal sind, solange nicht der im Meßzyklus folgende Sender freigegeben ist. Infolgedessen wird bei intaktem Empfänger E1 zwischen der Freigabe des Senders S2 und der darauffolgenden Freigabe des Senders S1 am Ausgang des UND-Gatters 9 das Kontrollsignal K1 erscheinen, während bei intaktem Empfänger E2 als Folge des vom Sender S1 ausgesandten Schalles das Kontrollsignal K2 erscheint. Die Kontrollsignale K1 und K2 werden zur Bildung eines Sammelkontrollsignals KS einem ODER-Gatter 11 zugeführt, dessen Ausgang eine nachtriggerbare Zeitstufe 12 mit der Kippzeit t_{F} + Δt beaufschlagt. t_{F} ist dabei der zeitliche Abstand, in welchem die Freigaben der Sender S1 bzw. S2 zyklisch aufeinander folgen. Eine nachtriggerbare Kippstufe wird bei jedem an ihrem Eingang auftretenden Signalwechsel von L- nach H-Signal neu gestartet, d.h. ihr Ausgangssignal behält das H-Signal bei, sofern nach einem Impuls ein weiterer in einem zeitlichen Abstand folgt, welcher kleiner ist als ihre Kippzeit. Wenn also im Betrieb der Rückwärtsfahrtsicherung die Kontrollsignale K1 und K2 in regelmäßiger Folge erscheinen, ist das invertierte Ausgangssignal ST der nachtriggerbaren Kippstufe 12 dauernd ein L-signal, während bei Ausfall eines Kontrollsignales K1 bzw. K2 das Signal ST ein L-Signal ist und eine Anzeigelampe 13 aufleuchten läßt. Es ist vorteilhaft, wenn von dem Störmeldesignal ST sofort die Ablaufsteuerung 5a angehalten wird, so daß die Möglichkeit einer Fehlerortung besteht.

Im unteren Teil der FIG 5 ist dargestellt, wie die erfindungsgemäße Überwachungseinrichtung 7 bei Einsatz von weiteren Wandlern zu ergänzen ist. Für je zwei Wandler - z.B. 3 und 4 - wäre eine bistabile Kippstufe und zwei UND-Gatter vorzusehen, welche in analoger Weise von den Senderfreigabesignalen FS3, FS4 und den Ausgangssignalen AE3, AE4 der entsprechenden Empfänger zu beaufschlagen wären. Die entsprechenden Kontrollsignale K3, K4 werden dann ebenfalls auf das ODER-Glied 11 zur Bildung des Sammelkontrollsignals KS geführt.

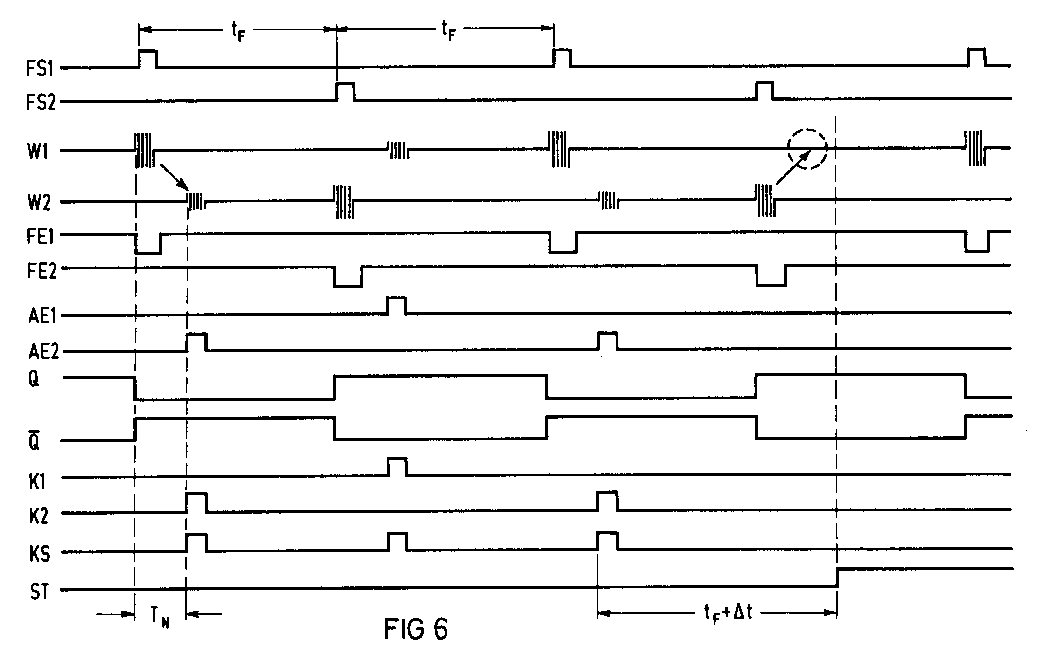

FIG 6 zeigt die zeitlichen Verläufe der in der Anordnung nach FIG 5 auftretenden Signale für den Fall, daß sich im Erfassungsbereich der Wandler kein Objekt befindet. Man erkennt, daß die Freigabesignale FS1 und FS2 für die Sender S1 und S2 im zeitlichen Abstand t_{F} aufeinanderfolgen und daß während dieser Zeit kurzzeitig ein hochfrequentes Spannungssignal W1 bzw. W2 - auch Burst genannt - auf die Wandler 1 bzw. 2 gegeben wird, welches nach relativ kurzer Laufzeit über den Nebenschluß vom jeweils benachbarten Wandler empfangen wird und die Digitalsignale AE1 bzw. AE2 bewirkt, welche ihrerseits in Konjunktion mit den Konnalen Q bzw. Q̅ zu den Kontrollsignalen K1 und K2 führen, welche durch Oderung als Signal KS gesammelt werden. Die Konjunktion, d.h. die UND-Verknüpfung der Signale AE1 und AE2 mit den Ausgangssignalen der bistabilen Kippstufe Q bzw. Q̅ ist deshalb wesentlich, weil sonst ein vom Sender S1 ausgesandtes und von einem Objekt reflektiertes Signal, welches vom zugeordneten Empfänger E1 aufgenommen wird, durch Erzeugung eines Kontrollimpulses K1 bei ausgefallenem Empfänger E2 einen ordnungsgemäßen Zustand der Rückwärtsfahrtsicherung vortäuschen könnte. Im rechten Teil des Impulsdiagramms nach FIG 6 ist ein Störfall ersichtlich gemacht, welcher darin besteht, daß nach Freigabe des Senders S2 infolge Ausfall des dem benachbarten Wandler zugeordneten Empfängers E1 kein Signal empfangen wird und daher während der Kippzeit t_{F} + Δt der nachtriggerbaren Kippstufe 12 der Kontrollimpuls K1 ausbleibt. Das Ausgangssignal der Kippstufe 12 wird daher zu einem L-Signal und das Störmeldesignal ST wird ein H-Signal, womit die Störung signalisiert und die Ablaufsteuerung angehalten wird.

Der FIG 6 ist entnehmbar, daß Δt kleiner sein muß, als der zeitliche Abstand t_{F} für aufeinanderfolgende Senderfreigaben.

Es ist es beim heutigen Stand der Technik ohne weiteres möglich, die Funktion der Ablaufsteuerung 5a, der Meßsignalauswertung 5b und der Überwachungseinrichtung 7 einem programmgesteuerten Mikroprozessor zu übertragen, was sich insbesondere bei mehr als zwei Wandlern empfehlen kann. Besonders einfach wird dann auch die Berücksichtigung der Veränderung der Schallaufzeiten infolge unterschiedlichen atmosphärischen Bedingungen, wie z.B. Luftdruck und Luftfeuchte, indem ja die Länge des erfindungsgemäß eingerichteten Nebenschlußweges konstant ist und deshalb die entsprechende meßbare Signallaufzeit - in FIG 6 mit T_{N} bezeichnet - als Vergleichsnormal für die Objektmessung, d.h. für die Berechnung des Abstandes zwischen Stoßstange und Objekt, verwendet werden kann. Damit wird ein hochgenaues Anfahren, z.B. an eine Laderampe, bei wechselnden Umwelteinflüssen möglich.

## Patentansprüche

1. Überwachungseinrichtung für Rückwärtsfahrtsicherungen bei Fahrzeugen mit mindestens zwei am Fahrzeugheck angeordneten, im Schallreflexionsverfahren betriebenen Sender-/Empfängerpaaren, denen jeweils ein elektroakustischer Wandler zugeordnet ist, **dadurch gekennzeichnet,** daß bei zur Objekterfassung zyklisch abwechselnd betriebenen Sender- Empfängerpaaren jeweils ein akustischer Nebenschluß zwischen zwei benachbarten Wandlern (1, 2 bzw. 3, 4) vorgesehen und jeweils das über den Nebenschluß von einem benachbarten Sender empfangene Signal als Funktionskontrollsignal (K1, K2 bzw. K3, K4) ausgewertet wird.

2. Einrichtung nach Anspruch 1, **gekennzeichnet** durch eine jedem Wandler (1, 2) zugeordnete elektronische Torschaltung (9, 10), der das Ausgangssignal des diesem Wandler zugeordneten Empfängers (E1, E2) zugeführt ist und die nur in der Zeit zwischen dem Beginn der Freigabe des einem benachbarten Wandler zugeordneten Senders und dem Beginn der im Meßzyklus folgenden Freigabe eines Senders durchlässig gesteuert wird.

3. Einrichtung nach Anspruch 2, **dadurch gekennzeichnet,** daß für jeweils zwei benachbarte Wandler (1, 2) eine bistabile Kippstufe (8) vorgesehen ist, welche eingangsseitig von den Freigabesignalen (FS1, FS2) der beiden zugehörigen Sendern beaufschlagt ist und deren Ausgangssginale den einen Eingängen zweier als Torschaltungen verwendeter UND-Gatter (9, 10) zugeführt sind, an deren anderen Ausgängen die Ausgangssignale (AE1, AE2) der beiden Empfänger (E1, E2) angeschlossen sind.

4. Einrichtung nach Anspruch 3, **dadurch gekennzeichnet,** daß die Ausgänge sämtlicher Torschaltungen bzw. UND-Gatter über ein ODER-Gatter (11) einer nachtriggerbaren Kippstufe (12) zugeführt sind, deren Kippzeit zwischen dem Einfachen und em Zweifachen des zeitlichen Abstandes (t_{F}) für aufeinanderfolgende Sender-Freigaben gewählt ist.

5. Einrichtung nach Anspruch 4, **dadurch gekennzeichnet,** daß vom Ausgangsignal der Kippstufe (12) ein Störmeldungssignal (ST) abgeleitet ist, welches zum Anhalten einer Sender-Empfänger-Ablaufsteuerung (5a) verwendbar ist.

6. Einrichtung nach einem der vorhergehenden Ansprüche, **dadurch gekennzeichnet,** daß der Objektmessung die jeweils ermittelte Schallaufzeit (T_{N}) über den akustischen Nebenschlußweg als Vergleichsnormal zugrundegelegt wird.

7. Einrichtung nach einem der vorhergehenden Ansprüche, **dadurch gekennzeichnet,** daß als Nebenschluß zwischen benachbarten Handlern zur Schalleitung geeignete Rohre oder Stäbe angeordnet sind.

8. Einrichtung nach Anspruch 7, **dadurch gekennzeichnet,** daß die Rohrenden abgeschrägt oder trichterförmig ausgebildet sind.

9. Einrichtung nach einem der Ansprüche 1 bis 6, **gekennzeichnet** durch mindestens eine jedem Wandler zugeordnete Schallreflexionsfläche (1b, 2b) zur teilweisen Umlenkung des Schalles in eine Richtung senkrecht zur Fahrzeuglängsachse.

10. Einrichtung nach Anspruch 9, **dadurch gekennzeichnet,** daß den Wandlern Schalltrichter (1a, 2a) zugeordnet sind und die Schallreflexionsflächen an den Innenwandungen der Schalltrichter befestigt sind.

11. Einrichtung nach Anspruch 9 oder 10, **dadurch gekennzeichnet,** daß die Schallreflexionsflächen (1c, 2c) konkav gewölbt sind.

## Claims

1. Monitoring apparatus for reverse-movement safety mechanisms in vehicles with at least two transmitter/receiver pairs arranged on the rear of the vehicle and used in a sound-reflection process, with which pairs there is associated in each case an electro-acoustic transducer, characterized in that with the transmitter/receiver pairs operated cyclically alternately for object detection there is provided in each case an acoustic shunt between two adjacent transducers (1, 2 and 3, 4) and in each case the signal received by way of the shunt by an adjacent transmitter is evaluated as a function control signal (K1, K2 and K3, K4).

2. Device according to claim 1, characterized by an electronic gate circuit (9, 10) associated with each transducer (1, 2), to which circuit there is supplied the output signal of the receiver (E1, E2) associated with this transducer and which is controlled in a conductive manner only in the period between the beginning of the enabling of the transmitter associated with an adjacent transducer and the beginning of the enabling of a transmitter following next in the measuring cycle.

3. Device according to claim 2, characterized in that for in each case two adjacent transducers (1, 2) a bistable flip-flop (8) is provided, which is loaded on the input side by the enabling signals (FS1, FS2) of the two respective transmitters and the output signals of which are supplied to the one set of inputs of the two AND gates (9, 10) used as gate circuits, to the other outputs of which gates the output signals (AE1, AE2) of the two receivers (E1, E2) are connected.

4. Device according to claim 3, characterized in that the outputs of all the gate circuits and AND gates are supplied by way of an OR gate (11) to a retriggerable flip-flop (12), the delay time of which is chosen to be between once and twice the time interval (t_{F}) for successive transmitter enablings.

5. Device according to claim 4, characterized in that a fault-indication signal (ST) is derived from the output signal of the flip-flop (12), which fault-indication signal can be used for stopping a transmitter-receiver sequencing control (5a).

6. Device according to one of the preceding claims, characterized in that the respectively determined sound propagation time (T_{N}) over the acoustic shunt path is taken as the basis for the object measurement as reference standard.

7. Device according to one of the preceding claims, characterized in that pipes or bars suitable for sound conduction are arranged as the shunt between adjacent transducers.

8. Device according to claim 7, characterized in that the pipe ends are constructed to be bevelled or funnel-shaped.

9. Device according to one of claims 1 to 6, characterized by at least one sound-reflection face (1b, 2b) associated with each transducer for the partial deflection of the sound into a direction perpendicular to the longitudinal axis of the vehicle.

10. Device according to claim 9, characterized in that sound funnels (1a, 2a) are associated with the transducers and the sound-reflection faces are fastened to the inner walls of the sound funnels.

11. Device according to claim 9 or 10, characterized in that the sound-reflection faces (1c, 2c) are concavely arched.

## Revendications

1. Dispositif de contrôle de systèmes de sécurité de marche arrière dans des véhicules, comportant au moins deux couples d'émetteur/récepteur qui sont disposés sur la partie arrière du véhicule, qui fonctionnent selon le procédé de réflexion acoustique et auxquels sont associés des transducteurs électro-acoustiques respectifs, caractérisé par le fait que, dans le cas de couples d'émetteur/récepteur fonctionnant cycliquement en alternance pour la détection d'objets, il est prévu respectivement une dérivation acoustique entre deux transducteurs voisins (1,2 et 3,4), et le signal reçu par un récepteur voisin par l'intermédiaire de la dérivation est évalué en tant que signal de contrôle de fonctionnement (K1,K2 et K3,K4).

2. Dispositif suivant la revendication 1, caractérisé par un circuit de porte électronique (9,10), qui est associé à chaque transducteur (1,2) et auquel le signal de sortie du récepteur (E1,E2) associé à ce transducteur est envoyé et qui est rendu passant uniquement pendant un intervalle de temps s'étendant entre le début de la libération de l'émetteur associé à un transducteur voisin et le début de la libération, qui intervient ensuite dans le cycle de mesure, d'un émetteur.

3. Dispositif suivant la revendication 2, caractérisé par le fait que pour respectivement deux transducteurs voisins (1,2), il est prévu un étage à bascule bistable (8), qui est chargé côté entrée par les signaux de libération (FS1,FS2) des deux émetteurs associés et dont les signaux de sortie sont envoyés à des premières entrées de deux portes ET (9,10) utilisées en tant que circuits de portes et aux autres sorties desquelles sont appliqués les signaux de sortie (AE1,AE2) des deux récepteurs (E1,E2).

4. Dispositif suivant la revendication 3, caractérisé par le fait que les sorties de tous les circuits de portes et de toutes les portes ET sont reliées par l'intermédiaire d'une porte OU (11) à un étage à bascule redéclenchable (12), dont le temps de basculement est choisi entre une fois et deux fois l'intervalle de temps (t_{F}) pour des libérations successives d'émetteur.

5. Dispositif suivant la revendication 4, caractérisé par le fait qu'à partir du signal de sortie de l'étage à bascule (12) est dérivé un signal (ST) de signalisation de perturbation, qui est utilisable pour bloquer une unité (5a) de commande de fonctionnement des émetteurs/récepteurs

6. Dispositif suivant l'une des revendications précédentes, caractérisé par le fait que pour la mesure d'un objet, on utilise, en tant que norme de référence, le temps de propagation du son (T_{N}) déterminé par l'intermédiaire d'un trajet de dérivation acoustique.

7. Dispositif suivant l'une des revendications précédentes, caractérisé par le fait que des tubes ou des barres appropriés sont disposés en tant que dérivation entre deux transducteurs voisins.

8. Dispositif suivant la revendication 7, caractérisé par le fait que les extrémités des tubes sont biseautées ou possèdent une forme d'entonnoir.

9. Dispositif suivant l'une des revendications 1 à 6, caractérisé par au moins une surface de réflexion du son (1b,2b), associée à chaque transducteur et servant à dévier partiellement le son dans une direction perpendiculaire à l'axe longitudinal du véhicule.

10. Dispositif suivant la revendication 9, caractérisé par le fait que des cornets acoustiques (1a,2a) sont associés aux transducteurs et que les surfaces de réflexion du son sont fixées sur les parois intérieures des cornets.

11. Dispositif suivant la revendication 9 ou 10, caractérisé par le fait que les surfaces (1c,2c) de réflexion du son sont concaves.
